# FASCICULE DE BREVET EUROPEEN

(11) **EP 2 099 060 B1**
(45) Date de publication et mention de la délivrance du brevet: **12.05.2010**
(21) Numéro de dépôt: 09354009.4
(22) Date de dépôt: 20.02.2009
(51) Int. Cl.: H01L 21/00, H01L 21/68, H01L 23/49

(54) **Procédé et dispositif de fabrication d'un assemblage d'au moins deux puces microélectroniques**
Verfahren und Vorrichtung zur Herstellung eines Montageverbunds aus mindestens zwei elektronischen Mikrochips
Method and device for manufacturing an assembly with at least two microelectronic chips

(30) Priorité: 06.03.2008 FR 0801234
(43) Date de publication de la demande: 09.09.2009
(73) Titulaire: Commissariat à l'Energie Atomique, 75015 Paris (FR)
(72) Inventeur: Brun, Jean, 38800 Champagnier (FR); Lepine, Benoît, 38000 Grenoble (FR); Mourey, Bruno, 38500 Coublevie (FR); Vicard, Dominique, 38330 Saint Nazaire les Eymes (FR)
(74) Mandataire: Hecké, Gérard

(56) Documents cités:
- JP-A- 2006 257 422
- US-B1- 6 932 136

## Description

### Domaine technique de l'invention

L'invention est relative à un procédé et un dispositif de fabrication d'un assemblage d'au moins deux puces microélectroniques.

### État de la technique

De nombreuses techniques existent aujourd'hui pour connecter mécaniquement et électriquement des puces microélectroniques entre elles. La technique conventionnelle consiste, une fois les puces formées sur un substrat et libérées par sciage, à réaliser une connexion mécanique rigide entre les puces. Les puces, alors fixées sur un support rigide, sont ensuite connectées électriquement avant qu'un enrobage de protection ne soit formé. Cette première approche, consistant à réaliser la connexion sur un support rigide, est classiquement utilisée lorsqu'il existe une grande complexité dans la connexion des puces. Cependant, cette approche a pour principal inconvénient d'utiliser un support mécanique rigide qui est particulièrement mal adapté à une intégration dans des structures souples.

Une deuxième approche, décrite dans le document WO-A-02/084617 consiste à intégrer des puces sur un ensemble de fibres ou d'éléments filaires afin de réaliser un dispositif. Cette intégration des puces au sein des fibres peut être réalisée par enrobage. Les différentes puces peuvent être reliées entre elles au moyen de filaments conducteurs pouvant être également enrobés ou intégrés au sein de la fibre elle même. Cependant ce document n'indique pas comment réaliser la fixation des filaments en matériau conducteur entre les différentes puces et l'enrobage sur les fibres.

### Objet de l'invention

L'invention a pour but un procédé de fabrication d'un assemblage de puces microélectroniques à forte cadence.

Selon l'invention, ce but est atteint par le fait que lesdites puces étant réalisées sur une plaquette et chaque puce comportant deux faces principales parallèles reliées par des faces latérales, au moins une des faces latérales comportant au moins une rainure, le procédé comporte les étapes successives suivantes :
- le collage de la plaquette sur un film souple,
- le découpage des puces,
- la déformation du film souple à proximité d'au moins une rainure d'au moins une puce pour rendre la rainure accessible,
- l'encastrement d'un élément filaire dans ladite rainure de ladite puce, disposée dans une zone d'insertion,
- et le décollement de la puce du film souple dans une zone de décollement.

Selon un développement de l'invention, la déformation du film, situé en aval d'une zone d'acheminement, est réalisée par inclinaison du film souple à proximité de ladite rainure, à l'entrée ou à la sortie.

La déformation du film peut être réalisée par une mise sous contrainte par traction, provoquant l'étirement du film au moins dans une zone d'acheminement.

L'invention concerne également un dispositif de fabrication d'un assemblage d'au moins deux puces microélectroniques, lesdites puces étant réalisées sur une plaquette et chaque puce comportant deux faces principales parallèles reliées par des faces latérales, au moins une des faces latérales comportant au moins une rainure, le dispositif comporte :
- des moyens de collage de la plaquette sur un film souple,
- des moyens de découpage des puces,
- des moyens de déformation du film souple à proximité d'au moins une rainure d'au moins une puce pour rendre la rainure accessible,
- des moyens d'encastrement d'un élément filaire dans ladite rainure de ladite puce, disposée dans une zone d'insertion ,
- et des moyens de décollement de la puce du film souple dans une zone de décollement.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
Les figures 1 à 6 représentent deux variantes de puces utilisable pour former une guirlande selon l'invention.
Les figures 7 et 8 illustrent les différentes étapes de réalisation d'une guirlande de puces selon l'invention.
Les figures 9 à 11 illustrent différentes variantes d'un premier mode de réalisation du procédé d'assemblage.
Les figures 12 et 13 illustrent deux variantes d'un second mode de réalisation du procédé d'assemblage.

### Description de modes préférentiels de réalisation

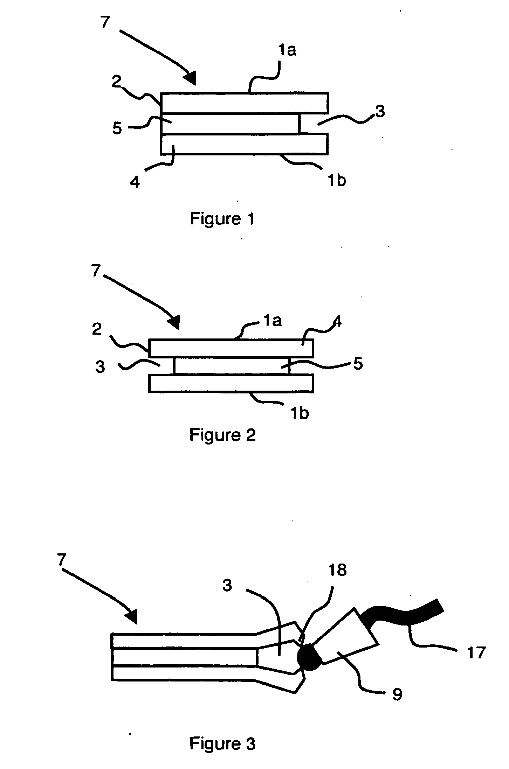

L'invention utilise des puces microélectroniques du type décrit dans la demande de brevet internationale PCT/FR2007/001034, revendiquant la priorité de la demande de brevet français n°0607588, déposée le 29 août 2006. Ces puces sont utilisées pour constituer un assemblage sous forme de guirlande. Comme illustré à la figure 1, la puce microélectronique comporte au moins un composant microélectronique 4. La puce microélectronique possède deux faces principales 1a et 1 b parallèles et reliées par des faces latérales 2 constituant la tranche de la puce. Le nombre de faces latérales 2 peut varier et dépend de la forme du contour des faces principales 1 a et 1 b. Au moins une des faces latérales comporte au moins une rainure 3, de préférence parallèle aux faces principales 1a et 1b. Cette rainure est dimensionnée de manière à permettre l'insertion d'un élément de forme filaire.

Comme illustré à la figure 2, une puce 7 peut comporter deux rainures 3 respectivement réalisées sur deux faces latérales opposées. Chaque rainure permet respectivement l'insertion d'un élément de forme filaire.

Une puce selon les figures 1 et 2 peut aussi se présenter sous la forme d'un assemblage de deux composants 4 microélectroniques ou d'un composant 4 microélectronique et d'une contreplaque reliés par une entretoise 5. L'entretoise est de largeur inférieure à la largeur des puces, permettant d'obtenir une rainure 3 (figure 1) ou deux rainures 3 (figure 2) de part et d'autre de l'entretoise 5.

Chaque rainure de chaque puce peut se présenter de manière inclinée, l'élément filaire restant, une fois encastré dans la rainure, d'axe sensiblement parallèle aux faces principales.

L'encastrement d'un élément filaire peut se faire en force, l'élément étant alors maintenu en place mécaniquement, ou par simple insertion après laquelle est réalisée une solidarisation par collage de l'élément filaire dans la rainure.

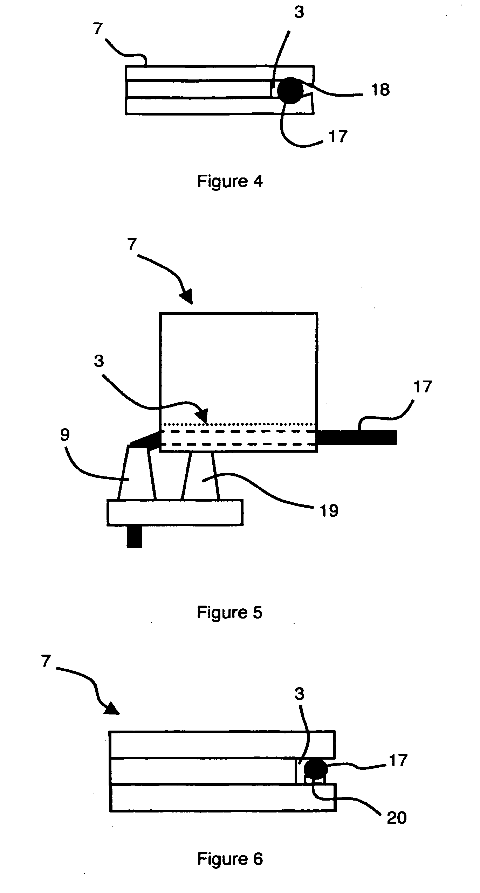

Selon une variante de réalisation de la puce illustrée aux figures 3 et 4, la rainure de la puce 7 peut se déformer de manière élastique lorsque l'élément filaire 17 est inséré. Puis, par retour élastique, la rainure vient pincer l'élément filaire 17 qui est alors encastré dans la rainure 3 de la puce. Avantageusement, la rainure 3 peut comporter à ses deux extrémités longitudinales des éléments 18 en saillie facilitant l'introduction de l'élément filaire et l'empêchant de se déboîter.

L'élément filaire est, de préférence, inséré dans la rainure de la puce 7 par une aiguille 9 porte-fil permettant de guider l'élément filaire 17 dans la rainure et/ou d'exercer une pression sur l'élément filaire 17 pour en forcer l'introduction dans la rainure 3. L'encastrement de l'élément filaire peut nécessiter une certaine place et il peut alors être nécessaire de rendre l'accès aux rainures suffisamment important pour laisser passer l'aiguille porte-fil ou tout autre dispositif d'insertion de l'élément filaire.

L'élément filaire peut être encastré dans la rainure d'une puce 7 par soudure, par collage ou par dépôt d'un polymère. À titre d'exemple illustré à la figure 5, correspondant à une vue de dessus d'une puce 7, l'élément filaire est inséré dans la rainure 3 par une aiguille 9 porte-fil puis une seringue 19 vient déposer la colle ou le polymère dans la rainure afin de sceller l'élément filaire 17 dans la rainure.

La rainure d'une puce peut être électriquement conductrice permettant d'alimenter la puce ou de servir de bus de données lorsque l'élément filaire, lui même électriquement conducteur, est en contact électrique avec la rainure. À titre d'exemple, la figure 6 illustre une puce dont la rainure comporte au moins un plot 20 de connexion électrique s'étendant sur au moins une partie ou sur toute la rainure 3. L'élément filaire 17 peut alors être électriquement en contact avec le plot 20.

Afin d'optimiser le contact entre le plot et l'élément filaire ces derniers peuvent subir une électrolyse ou être scellé dans une colle, ou un polymère, électriquement conducteur.

Selon une variante (non représentée), l'élément filaire peut être partiellement inséré dans une rainure et ne relier que deux puces adjacentes, la liaison avec une autre puce étant réalisée par un autre élément filaire.

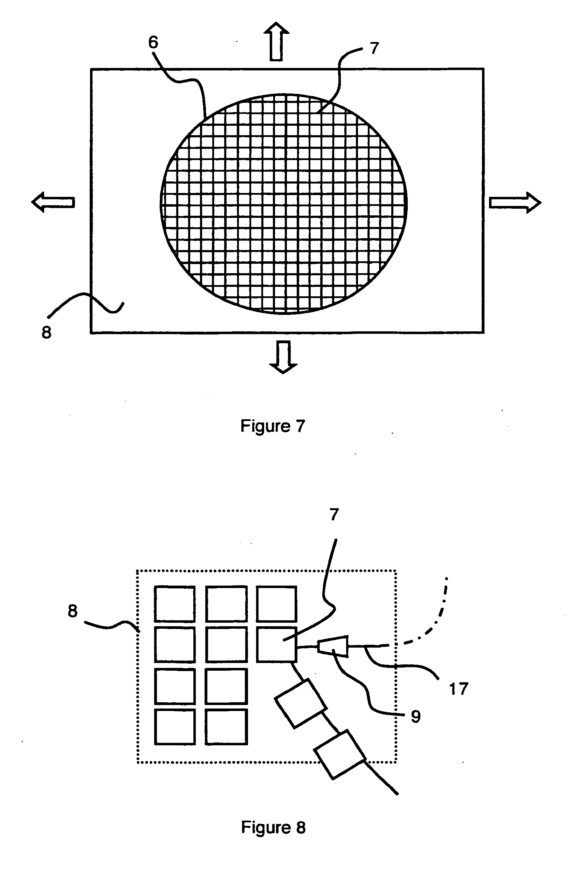

Comme illustré à la figure 7, les puces 7 microélectroniques telles que décrite ci-dessus sont réalisées côte à côte sur une plaquette 6 de silicium. Afin de réaliser une guirlande de puces, le procédé de fabrication d'un assemblage d'au moins deux puces microéléctroniques telles que définies ci-dessus, illustré aux figures 7 à 13, comporte les étapes successives suivantes :
- la plaquette 6 de silicium sur laquelle ont été réalisées les puces 7 est collée sur un film 8 souple, le film peut être collé avant réalisation des puces sur la plaquette ou après réalisation des puces,
- les puces initialement réalisées, de préférence, sous forme de quadrillage sur la plaquette 6 sont découpée, elles restent néanmoins mécaniquement solidaires les unes des autres par l'intermédiaire du film 8 souple sur lequel elles sont collées. Ce découpage peut être réalisé par tout procédé adapté, par exemple, par sciage ou par gravure plasma,
- la déformation du film 8 souple à proximité d'au moins une rainure 3 d'au moins une puce pour rendre la rainure 3 accessible,
- l'encastrement d'au moins un élément filaire 17 dans ladite rainure 3 de ladite puce, disposée dans une zone d'insertion 12,
- et le décollement de la puce du film 8 souple dans une zone de décollement 13.

Les trois dernières étapes peuvent être répétées tant que la guirlande n'a pas la longueur voulue.

Selon un développement, les zones d'insertion et de décollement sont identiques.

Le film souple peut être un film polymère.

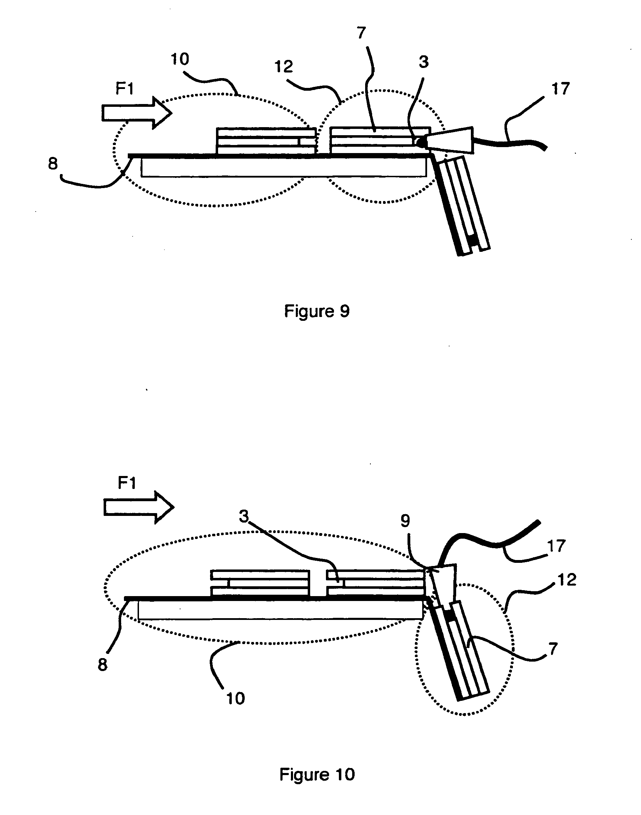

Selon un mode de réalisation illustré aux figures 9 à 11 la déformation consiste en une inclinaison du film souple au niveau d'une zone d'insertion 12 afin de permettre l'accès aux rainures. Ainsi, la déformation du film souple situé en aval d'une zone d'acheminement 10 est réalisée par inclinaison du film 8 souple à proximité de la rainure.

Dans une variante illustrée à la figure 9, chaque puce comporte une rainure 3 se présentant en aval selon le sens de défilement du film 8 souple indiqué par la flèche F1. Afin de permettre l'insertion de l'élément filaire dans les rainures de deux puces adjacentes, la déformation comprend une inclinaison du film 8 souple au niveau de la rainure 3, faisant ainsi basculer une première puce par inclinaison du film souple en sortie de la zone d'insertion 12, laissant ainsi libre d'accès la rainure 3 d'une seconde puce 7 alors placée dans la zone d'insertion 12. L'élément filaire 17 est alors inséré dans la rainure 3 au niveau de la zone d'insertion 12 se situant à la cassure formée par l'inclinaison du film 8 en sortie de la zone d'insertion 12. Une fois l'élément filaire 17 inséré, le film 8 souple défile afin d'amener la puce située dans la zone d'insertion 12 vers la zone de décollement et d'amener la puce suivante sur la zone d'insertion 12, etc. À la sortie de la zone d'insertion 12, le film 8 fait avec la direction de défilement des puces un angle légèrement supérieur à 90° dans le mode de réalisation particulier illustré à la figure 9.

Selon une variante illustrée à la figure 10, chaque puce comporte une rainure se présentant en amont selon le sens de défilement du film souple (indiqué par F1). Dans cette variante, la zone d'insertion 12 est inclinée par rapport à la zone d'acheminement 10. Le film souple est incliné à l'entrée de la zone d'insertion 12. Ainsi, la puce 7, dans laquelle l'élément filaire doit être inséré, bascule vers la zone de d'insertion, dégageant la rainure 3 et permettant l'insertion de l'élément filaire 17. Ensuite, le film 8 souple défile afin d'amener la puce suivante dans la zone d'insertion 12, la puce dans laquelle l'élément filaire a été inséré peut être amenée dans une zone de décollement (non représentée) ou être décollée au niveau de la zone d'insertion 12 avant qu'une nouvelle puce y soit placée.

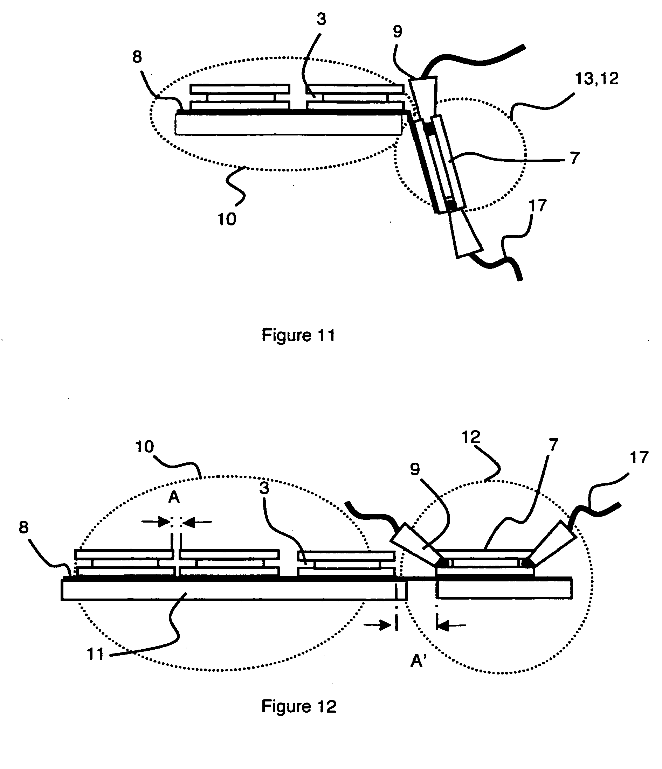

Selon une variante illustrée à la figure 11, chaque puce comporte deux rainures. Les rainures sont réalisées sur deux faces latérales opposées, une rainure étant située en amont et l'autre rainure étant située en aval selon le sens de défilement du film 8 souple. Dans cette variante, la zone d'insertion 12 est inclinée par rapport à la zone d'acheminement 10. Ainsi, la puce 7, dans laquelle deux éléments filaires doivent être insérés, bascule sur la zone d'insertion 12, dégageant les deux rainures 3 et permettant l'insertion des éléments filaires dans les deux rainures. Le film 8 souple est donc incliné à l'entrée de la zone d'insertion 12. Avant d'amener une puce sur la zone d'insertion 12 la puce précédente est, de préférence, décollée, afin de laisser libre la rainure située en aval selon le défilement des puces. Le décollement des puces peut être effectué dans la zone d'insertion 12 (les zones de décollement 13 et d'insertion 12 étant alors identiques). La puce située dans la zone d'insertion 12 peut aussi être déplacée vers une zone de décollement, située en aval, lorsqu'une puce suivante arrive sur la zone d'insertion 12 afin de laisser libre la rainure située en aval selon le défilement des puces.

Afin d'augmenter la cadence d'assemblage des puces, ce mode de réalisation peut être appliqué non plus à une puce mais à une rangée de puce, chaque rangée de puce passant successivement d'une zone à l'autre. L'utilisation d'une rangée de puces à la place d'une puce s'applique aussi à tous les modes de réalisation.

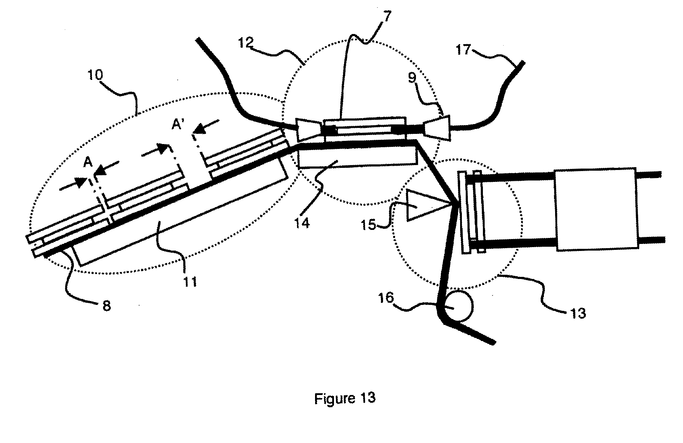

Dans un second mode de réalisation illustré aux figures 12 et 13, la déformation du film 8 souple est réalisée par la mise sous contrainte du film 8 souple par traction, provoquant l'étirement de ce dernier au moins dans la zone d'acheminement 10. Une fois le film 8 souple étiré (Flèches figure 7) lors de son passage dans la zone de d'acheminement 10, l'espacement entre deux puces adjacentes au niveau de la zone d'insertion 12 est suffisant pour permettre le passage de l'élément filaire et/ou l'aiguille porte-fil 9. Ainsi, la zone de déformation correspond à la zone d'acheminement 10 des puces vers la zone d'insertion 12.

Le film souple 8 peut être un film polymère pouvant s'étirer de quelques dizaines de pourcent lorsqu'il est soumis à une température prédéterminée. Ainsi, le film polymère peut être mis sous contrainte par traction, et/ou chauffé jusqu'à la température permettant son étirement. Un tel film permet, après découpe des puces, de créer un espacement entre les puces de quelques millimètres. À titre d'exemple, le film contraint peut être amené sur une plaque chauffante 11, de préférence entre 80°C et 150°C, la contrainte exercée à une température donnée permettant l'écartement des puces entre elles au niveau des rainures. Cet écartement peut faciliter l'accès aux rainures par au moins une aiguille porte fil 9 aidant à l'insertion de l'élément filaire 17 dans la rainure.

Comme illustré à la figure 12, le film 8 souple sur lequel est collée la plaquette, dont les puces 7 ont été découpées, passe successivement dans au moins deux zones différentes formant une chaîne de production permettant d'accélérer la cadence de fabrication des guirlandes. Ainsi, le film souple est tout d'abord amené dans la zone de d'acheminement 10 pouvant comporter une plaque chauffante 11. Cette plaque 11 permet, si nécessaire, de chauffer le film 8 à sa température d'étirement afin de créer l'espacement entre les puces. Cet espacement s'agrandit (de A à A' par exemple) au fur et à mesure du déplacement du film dans la zone d'acheminement 10. Ensuite, le film 8 est entraîné dans une zone d'insertion 12 des fils 17 dans les rainures, et enfin dans une zone de décollement (non représentée) destinée au décollement des puces 7 formant la guirlande. La zone de décollement peut coïncider avec la zone d'insertion.

Selon une variante illustrée à la figure 13 la zone d'insertion 12 comporte une surface d'appui 14. Avantageusement, cette surface 14 n'est pas dans le même plan que la plaque chauffante 11 afin de faciliter le passage des aiguilles 9 porte-fil si l'étirement n'est pas suffisant pour permettre leur passage. L'intersection des plans formés respectivement par la plaque chauffante 11 et la surface 14 forme un angle rentrant, cet angle est de préférence strictement supérieur à 180° et strictement inférieur à 360°. Cette configuration permet de faciliter le déplacement de l'aiguille porte-fil 9 et l'insertion du fil 17 dans les rainures de chaque puce.

Selon ce deuxième mode de réalisation et ses variantes, la cadence de fabrication de la guirlande peut être accélérée par l'ajout, à chaque étape élémentaire, non plus d'une puce à la fois mais d'une rangée de puces. Pour cela, la plaquette comporte une pluralité de rangées de puces sensiblement parallèles entre elles et chaque rangée de puces passe successivement de la zone d'acheminement 10 à la zone d'insertion 12 puis à la zone de décollement 13. Dans la zone de décollement 13, une simple traction sur la guirlande peut permettre de décoller les puces.

Selon un perfectionnement applicable aux différents modes de réalisation, le décollement de chaque puce 7 ou de chaque rangée de puces est favorisé par l'utilisation dans la zone de décollement 13 d'un outil 15 (figure 13) permettant de réduire la surface d'adhésion entre la puce 7 ou la rangée de puces et le film 8. Cet outil 15 peut se présenter sous la forme d'une lame ou d'une pointe faisant pression sur une zone médiane de chaque puce alors que le film 8 se déplace grâce à des moyens d'entraînement du film. À titre d'exemple sur la figure 13, un galet 16 sur lequel le film 8 prend appui est disposé à la sortie de la zone de décollement 13 et permet à l'outil 15 de réduire la surface de la puce collée au film afin d'en faciliter le décollement.

Si les moyens d'entraînement du film permettent sa mise en contrainte par traction, selon le deuxième mode de réalisation illustré à la figure 13, la traction reste sensiblement constante dans les zones d'acheminement 10, d'insertion 12 et de décollement 13. Cette traction permet d'obtenir dans la zone d'acheminement 10 les espacements A puis A', lors du passage du film sur la plaque chauffante 11 ou de son simple étirement par traction.

Après décollement, la partie libre de la guirlande peut suivre un cheminement permettant divers traitements, par d'exemple une électrolyse, pour renforcer les connexions entre les fils et les puces, ou l'enduction d'une colle, d'un polymère, etc.

Chaque élément filaire 17, reliant les puces pour former la guirlande, peut avoir un diamètre de quelques micromètres, de préférence entre 10µm et 300µm, adapté aux dimensions des rainures des puces. L'élément filaire 17 peut être métallique, de préférence constitué par au moins un métal conducteur de type Ag, Au, etc. De manière avantageuse, l'élément filaire peut aussi être formé d'un toron constitué de plusieurs fils élémentaires dont au moins un est conducteur. Les rainures des puces peuvent alors servir de bornes de connexion électrique, de bus de données, etc.

De plus, les puces peuvent aussi intégrer des zones de connexions sur leurs surfaces supérieures et/ou inférieures de manière à augmenter le nombre de connexions possibles ou de renforcer leur tenue mécanique une fois assemblées sous forme de guirlande.

Les éléments filaires peuvent être des fils isolants polymères participant à la tenue mécanique ou encore des fibres textiles revêtues d'un matériau conducteur.

Les éléments filaires peuvent être creux, permettant ainsi la circulation d'un fluide, de préférence liquide ou gazeux, dans le canal formé par le diamètre interne du fil. Le fluide circulant dans le canal peut, par exemple, assurer le refroidissement des puces formant la guirlande. L'utilisation d'un système de refroidissement permet alors d'intégrer à la guirlande des puces plus complexes et fonctionnant à fréquences plus élevées.

Une guirlande de puces microélectroniques obtenue selon le procédé décrit ci-dessus permet notamment d'associer dans un textile une pluralité de puces réalisant une fonction précise commune ou une fonction particulière.
Les puces peuvent être de type RFID, le fil métallique les reliant pouvant alors servir d'antenne permettant notamment leur alimentation.

L'invention n'est pas limitée aux modes de réalisation décrits ci-dessus. En particulier, différents types de puces provenant de substrats distincts peuvent être connectés.

Un dispositif de fabrication permet de réaliser un assemblage d'au moins deux puces microélectroniques réalisées sur une plaquette, chaque puce 7 comporte deux faces principales 1a et 1b parallèles reliées par des faces latérales 2. Au moins une des faces latérales 2 comporte au moins une rainure 3, le dispositif comporte :
- des moyens de collage de la plaquette 6 sur un film 8 souple,
- des moyens de découpage des puces 7,
- des moyens de déformation du film souple à proximité d'au moins une rainure d'au moins une puce pour rendre la rainure accessible,
- des moyens d'insertion d'un élément filaire 17 dans ladite rainure 3 de ladite puce,
- et des moyens de décollement de la puce du film souple dans une zone de décollement 13, l'élément filaire 17 étant encastré dans ladite puce.

## Revendications

1. Procédé de fabrication d'un assemblage d'au moins deux puces microélectroniques, **caractérisé en ce que** lesdites puces étant réalisées sur une plaquette (6) et chaque puce (7) comportant deux faces principales (1 a,1 b) parallèles reliées par des faces latérales (2), au moins une des faces latérales (2) comportant au moins une rainure (3), le procédé comporte les étapes successives suivantes :
- le collage de la plaquette (6) sur un film (8) souple,
- le découpage des puces (7),
- la déformation du film souple à proximité d'au moins une rainure d'au moins une puce pour rendre la rainure (3) accessible,
- l'encastrement d'un élément filaire (17) dans ladite rainure (3) de ladite puce, disposée dans une zone d'insertion (12)
- et le décollement de la puce du film souple dans une zone de décollement (13).

2. Procédé selon la revendication 1, **caractérisé en ce que** la déformation du film (8), situé en aval d'une zone d'acheminement (10), est réalisée par inclinaison du film souple à proximité de ladite rainure.

3. Procédé selon la revendication 2, **caractérisé en ce que** le film (8) est incliné à l'entrée de la zone d'insertion (12).

4. Procédé selon l'une quelconque des revendication 2 et 3, **caractérisé en ce que** le film (8) souple est incliné à la sortie de la zone d'insertion (12).

5. Procédé selon la revendication 1, **caractérisé en ce que** la déformation du film (8) est réalisée par une mise sous contrainte par traction, provoquant l'étirement du film (8) au moins dans une zone d'acheminement (10).

6. Procédé selon la revendication 5, **caractérisé en ce que** la zone d'acheminement (10) est munie d'une plaque chauffante (11).

7. Procédé selon l'une quelconque des revendications 1 à 6, **caractérisé en ce que** les zones d'insertion (12) et de décollement (13) sont identiques.

8. Procédé selon l'une quelconque des revendications 1 à 7, **caractérisé en ce que** le film (8) souple est un film polymère.

9. Procédé selon l'une quelconque des revendications 1 à 8, **caractérisé en ce que** chaque puce (7) comporte deux rainures (3), respectivement réalisées sur deux faces latérales (2) opposées, deux puces adjacentes étant reliées par deux fils, lesdits fils étant insérés dans les rainures (3) par des aiguilles (9) porte-fil.

10. Procédé selon l'une quelconque des revendications 1 à 9, **caractérisé en ce qu'**une plaquette est formée d'une pluralité de rangées de puces, chaque rangée passant successivement d'une zone à l'autre.

11. Procédé selon l'une quelconque des revendications 1 à 10, **caractérisé en ce que** la zone de décollement (13) comporte un outil (15) de décollement constitué par une lame ou par au moins une pointe.

12. Dispositif de fabrication d'un assemblage d'au moins deux puces microélectroniques, **caractérisé en ce que** lesdites puces étant réalisées sur une plaquette (6) et chaque puce (7) comportant deux faces principales (1a, 1b) parallèles reliées par des faces latérales (2), au moins une des faces latérales (2) comportant au moins une rainure (3), le dispositif comporte :
- des moyens de collage de la plaquette (6) sur un film (8) souple,
- des moyens de découpage des puces (7),
- des moyens de déformation du film souple (8) à proximité d'au moins une rainure (3) d'au moins une puce (7) pour rendre la rainure (3) accessible,
- des moyens d'encastrement d'un élément filaire (17) dans ladite rainure (3) de ladite puce, disposée dans une zone d'insertion (12),
- et des moyens de décollement de la puce du film souple dans une zone de décollement (13).

## Claims

1. A method for fabricating an assembly of at least two microelectronic chips, **characterised in that** said chips being made on a wafer (6) and each chip (7) comprising two parallel main faces (1 a, 1 b) joined by side faces (2), at least one of the side faces (2) comprising at least one groove (3), the method comprises the following successive steps:
- sticking the wafer (6) onto a flexible film (8),
- cutting the chips (7),
- deformation of the flexible film in the proximity of at least one groove of at least one chip to make the groove (3) accessible,
- embedding a thread element (17) in said groove (3) of said chip, arranged in an insertion area (12),
- and removing the chip from the flexible film in a removal area (13).

2. The method according to claim 1, **characterised in that** deformation of the film (8), located downline from an input area (10), is achieved by inclining the flexible film in proximity to said groove.

3. The method according to claim 2, **characterised in that** the film (8) is inclined on entry to the insertion area (12).

4. The method according to anyone of claims 2 and 3, **characterised in that** the flexible film (8) is inclined on exit from the insertion area (12).

5. The method according to claim 1, **characterised in that** deformation of the film (8) is achieved by stressing by traction causing stretching of the film (8) at least in an input area (10).

6. The method according to claim 5, **characterised in that** the input area (10) is equipped with a heating plate (11).

7. The method according to anyone of claims 1 to 6, **characterised in that** the insertion area (12) and removal area (13) are identical.

8. The method according to anyone of claims 1 to 7, **characterised in that** the flexible film (8) is a polymer film.

9. The method according to anyone of claims 1 to 8, **characterised in that** each chip (7) comprises two grooves (3), respectively made on two opposite side faces (2), two adjacent chips being connected by two threads, said threads being inserted in the grooves (3) by thread-bearing needles (9).

10. The method according to anyone of claims 1 to 9, **characterised in that** a wafer is formed by a plurality of rows of chips, each row passing successively from one area to the other.

11. The method according to anyone of claims 1 to 10, **characterised in that** the removal area (13) comprises a removal tool (15) formed by a blade or at least a tip.

12. A device for fabricating an assembly of at least two microelectronic chips, **characterised in that** said chips being made on a wafer (6) and each chip (7) comprising two parallel main faces (1 a, 1 b) joined by side faces (2), at least one of the side faces (2) comprising at least one groove (3), the device comprises:
- means for sticking the wafer (6) on a flexible film (8),
- means for cutting the chips (7),
- means for deforming the flexible film (8) in proximity to at least one groove (3) of at least one chip (7) to make the groove (3) accessible,
- means for embedding a thread element (17) in said groove (3) of said chip, arranged in an insertion area (12),
- and means for removing the chip from the flexible film (8) in a removal area (13).

## Patentansprüche

1. Verfahren zur Herstellung einer Verbindung aus mindestens zwei Mikroelektronik-Chips, **dadurch gekennzeichnet, dass**, nachdem die genannten Chips auf einem Wafer (6) ausgeführt sind und jeder Chip (7) zwei parallele Hauptseiten (1a, 1b) hat, die durch Seitenflächen (2) miteinander verbunden sind, wobei mindestens eine der Seitenflächen (2) mindestens eine Rille (3) aufweist, das Verfahren folgende aufeinanderfolgende Schritte umfasst:
- das Kleben des Wafers (6) auf eine biegsame (8) Folie,
- das Zerschneiden der Chips (7),
- die Verformung der biegsamen Folie nahe mindestens einer Rille mindestens eines Chips, um die Rille (3) zugänglich zu machen,
- das Einfügen eines Drahtelements (17) in die genannte Rille (3) des Chips, die in einem Einfügebereich (12) angeordnet ist,
- und das Abnehmen des Chips von der biegsamen Folie in einem Abnahmebereich (13).

2. Verfahren nach Anspruch 1, **dadurch gekennzeichnet, dass** die Verformung der Folie (8), die sich nachgeordnet einem Zuführbereich (10) befindet, durch Schräganordnung der biegsamen Folie nahe der genannten Rille erfolgt.

3. Verfahren nach Anspruch 2, **dadurch gekennzeichnet, dass** die Folie (8) am Eintritt zum Einfügebereich (12) schräg angeordnet ist.

4. Verfahren nach einem der Ansprüche 2 und 3, **dadurch gekennzeichnet, dass** die biegsame Folie (8) am Ausgang des Einfügebereichs (12) schräg angeordnet ist.

5. Verfahren nach Anspruch 1, **dadurch gekennzeichnet, dass** die Verformung der Folie (8) durch Zugbeanspruchung erfolgt, wodurch die Folie (8) zumindest in einem Zuführbereich (10) gereckt wird.

6. Verfahren nach Anspruch 5, **dadurch gekennzeichnet, dass** der Zufuhrbereich (10) mit einer Heizplatte (11) versehen ist.

7. Verfahren nach einem der Ansprüche 1 bis 6, **dadurch gekennzeichnet, dass** der Einfügebereich (12) und der Abnahmebereich (13) identisch miteinander sind.

8. Verfahren nach einem der Ansprüche 1 bis 7, **dadurch gekennzeichnet, dass** die biegsame Folie (8) eine Polymerfolie ist.

9. Verfahren nach einem der Ansprüche 1 bis 8, **dadurch gekennzeichnet, dass** jeder Chip (7) zwei Rillen (3) hat, die jeweils an zwei entgegengesetzten Seitenflächen (2) ausgeführt sind, wobei zwei angrenzende Chips durch zwei Drähte verbunden sind, welche Drähte mittels Drahtträgernadeln (9) in die Rillen (3) eingefügt sind.

10. Verfahren nach einem der Ansprüche 1 bis 9, **dadurch gekennzeichnet, dass** aus einer Mehrzahl von Chipreihen ein Wafer gebildet wird, wobei jede Reihe nacheinander von einem Bereich zum nächsten geführt wird.

11. Verfahren nach einem der Ansprüche 1 bis 10, **dadurch gekennzeichnet, dass** der Abnahmebereich (13) ein Abnahmewerkzeug (15) umfasst, das aus einer Zunge oder aus mindestens einer Spitze besteht.

12. Verfahren zur Herstellung einer Verbindung aus mindestens zwei Mikroelektronik-Chips, **dadurch gekennzeichnet, dass**, nachdem die Chips auf einem Wafer (6) ausgeführt sind und jeder Chip (7) zwei parallele Hauptseiten (1a, 1b) aufweist, die durch Seitenflächen (2) miteinander verbunden sind, und mindestens eine der Seitenflächen (2) mindestens eine Rille (3) aufweist, die Vorrichtung folgende Teile umfasst:
- Mittel zum Kleben des Wafers (6) auf eine biegsame Folie (8),
- Mittel zum Zerschneiden der Chips (7),
- Mittel zur Verformung der biegsamen Folie (8) nahe mindestens einer Rille (3) mindestens eines Chips (7), um die Rille (3) zugänglich zu machen,
- Mittel zum Einfügen eines Drahtelements (17) in die genannte Rille (3) des Chips, die in einem Einfügebereich (12) angeordnet ist,
- und Mittel zum Abnehmen des Chips von der biegsamen Folie in einem Abnahmebereich (13):
